# EUROPÄISCHE PATENTSCHRIFT

(11) **EP 0 730 348 B1**
(45) Veröffentlichungstag und Bekanntmachung des Hinweises auf die Patenterteilung: **30.05.2001**
(21) Anmeldenummer: 95117025.7
(22) Anmeldetag: 28.10.1995
(51) Int. Cl.: H03K 17/18

(54) **Schaltung zum Ein- und Ausschalten einer elektrischen Last**
Circuit for turning on and off an electrical load
Montage pour la mise en circuit et hors circuit d'une charge électrique

(30) Priorität: 01.03.1995 DE 19507071
(43) Veröffentlichungstag der Anmeldung: 04.09.1996
(73) Patentinhaber: ROBERT BOSCH GMBH, 70442 Stuttgart (DE)
(72) Erfinder: Krieger, Klaus, D-73249 Wernau (DE); Boettigheimer, Andreas, D-72639 Neuffen (DE); Schmidt, Jürgen, D-73614 Schorndorf (DE)

(56) Entgegenhaltungen:
- EP-A- 0 011 680
- EP-A- 0 413 938
- EP-A- 0 730 349
- EP-A- 0 730 350
- DE-A- 3 338 627
- DE-A- 3 909 613
- DE-A- 4 413 194
- US-A- 4 599 675

## Beschreibung

### Stand der Technik

Die Erfindung geht aus von einer Schaltung zum Ein- und Ausschalten einer elektrischen Last nach der Gattung des unabhängigen Anspruchs. Aus der EP-A 11 680 ist eine in einem Airbag-Steuergerät enthaltene Endstufenschaltung bekannt, die aus Sicherheitsgründen zwei in Reihe mit der Last geschaltete Schalttransistoren aufweist. Als Last ist ein Heizelement vorgesehen, das eine Treibladung zum Aufblasen des Airbags thermisch zündet. Komparatoren, die an der Schaltstrecke eines der beiden in Reihe geschalteten Endstufentransistoren angeschlossen sind, ermöglichen eine Funktionskontrolle der Transistoren durch Ein- und Ausschalten entweder des einen oder des anderen Transistors. Bei dieser Schaltungsauslegung kann eine Überprüfung der Transistoren nur vorgenommen werden, wenn die Last zwischen den beiden Transistoren angeordnet ist. Eine Überprüfung, ob ein Einschaltsignal für die Last vorliegt, kann mit der vorbekannten Schaltung nicht durchgeführt werden, da diese Überprüfung gleichbedeutend mit der Auslösung der Zündung ist.

Aus der DE-A 33 38 627 ist eine weitere Schaltung zum Ein- und Ausschalten einer elektrischen Last bekannt geworden, die zwei in Reihe mit der Last geschaltete Halbleiterschalter enthält. Vorgesehen ist die Reihenschaltung eines Feldeffekttransistors und eines Bipolartransistors. Die vorbekannte Schaltung eignet sich für hohe Sperrspannungen, obwohl ein Feldeffekttransistor verwendet werden kann, der für wesentlich niedrigere Sperrspannungen ausgelegt ist.

Aus der EP-A 413 938 ist eine Schaltung zur Überwachung des Schaltstatus eines Leistungstransistors bekannt, bei der ein Komparator parallel zur Last geschaltet ist, an dessem Ausgang ein Einschaltzustandssignal abgreifbar ist. Das Einschaltzustandssignal wird mit einem Einschaltsignal des Leistungstransistors verglichen.

Der Erfindung liegt die Aufgabe zugrunde, eine Schaltung zum zuverlässigen Ein- und Ausschalten einer elektrischen Last anzugeben, wobei die eingesetzten wenigstens zwei in Reihe geschalteten Halbleiterschalter überprüfbar sind.

Die Aufgabe wird durch die im unabhängigen Anspruch angegebenen Merkmale gelöst.

### Vorteile der Erfindung

Vorgesehen sind ein erster Halbleiterschalter oder eine erste Halbleiterschaltergruppe und wenigstens ein zweiter Halbleiterschalter oder wenigstens eine zweite Halbleiterschaltergruppe. Die beiden Halbleiterschalter sind in Reihe mit der Last geschaltet, wobei es auf die Reihenfolge der Anordnung nicht ankommt.

Die erfindungsgemäße Schaltung zum Ein- und Ausschalten einer elektrischen Last weist den Vorteil einer erhöhten Sicherheit auf, die dadurch erzielt wird, dass im normalen Betrieb oder während einer Diagnose die an der Last abfallende Spannung in einem Komparator mit einem Schwellenwert verglichen wird. Der Komparator stellt ein Signal bereit, das den Einschaltzustand der Last anzeigt. Dieses Signal ermöglicht insbesondere eine Überprüfung der Halbleiterschalter unter Verwendung eines Vergleichers, der das Einschaltzustandssignal mit einem Signal vergleicht. Das Signal enthält die Information, ob die Last eingeschaltet oder ausgeschaltet sein soll.

Vorgesehen ist eine Auswahlschaltung, welche die Veranlassung von Steuersignalen, getrennt für jeden Halbleiterschalter, ermöglicht, die einem Einschalt- oder Ausschaltsignal entsprechen. Die Auswahlschaltung unterscheidet zwischen einer ersten und einer zweiten Zeitdauer der Schaltsignalvorgabe. Die Auswahlschaltung gibt weiterhin ein Statussignal zum Vergleicher ab, das einen von den Schaltsignalen festgelegten Einschalt- oder Ausschaltzustand der Last wiedergibt.

Die erfindungsgemäße Schaltung ermöglicht eine Überprüfung, ob bei einem vorgegebenen Einschaltzustand oder Ausschaltzustand der Last das Einschaltzustandsignal vorliegt oder nicht. Da die von der Auswahlschaltung bereitgestellten Signale unabhängig von einem externen Schaltsignal sind, kann mit der Auswahlschaltung der eine und der andere Halbleiterschalter getrennt eingeschaltet werden. Es ist somit möglich, einen defekten Halbleiterschalter festzustellen. Wenn eine externe Einschaltvorgabe vorliegt, kann die Auswahlschaltung den einen oder den anderen Halbleiterschalter abschalten und somit gleichfalls die Überprüfung vornehmen. Die Auswahlschaltung kann die beiden Steuersignale auch derart festlegen, dass sie gleichzeitig entweder einem Einschalt- oder einem Ausschaltzustand entsprechen. Die erste Zeitdauer kann derart festgelegt werden, dass ein elektrischer Verbraucher, der die elektrische Last enthält, von dem kurzzeitigen Ein- oder Ausschalten der elektrischen Last nicht weiter beeinflusst ist. Ein solcher Verbraucher weist vorzugsweise eine Verzögerungszeit zwischen dem Auftreten des Ein-/Ausschaltsignals und dem entsprechenden Ein- oder Ausschaltzustand auf. Mit dieser Maßnahme kann neben den Halbleiterschaltern auch die Last selbst überprüft werden. Durch die Vorgabemöglichkeit einer zweiten Zeitdauer, die länger ist als die erste Zeitdauer, kann neben der Überprüfung der Last auch eine Überprüfung des die Last enthaltenden Verbrauchers stattfinden. Die zweite Zeitdauer ist derart festzulegen, dass ein Signal, welches das Arbeiten des Verbrauchers anzeigt, seinen Zustand ändert. Damit ist beispielsweise ein Abschalttest realisierbar.

Vorteilhafte Weiterbildungen und Ausgestaltungen der erfindungsgemäßen Schaltung ergeben sich aus abhängigen Ansprüchen.

Eine erste Ausgestaltung sieht vor, dass das dem Vergleicher zugeführte Schaltsignal ein einer Steuerschaltung zugeführtes externes Schaltsignal ist, mit welchem vorgegeben ist, ob die Last ein- oder ausgeschaltet sein soll. Bei vom Vergleicher festgestellten Abweichungen wird beispielsweise ein Warnsignal ausgelöst und/oder beispielsweise sichergestellt, dass ein Einschalten der Last nicht mehr möglich ist.

Eine Weiterbildung der erfindungsgemäßen Schaltung sieht vor, dass die verwendeten Halbleiterschalter unterschiedliche Eigenschaften aufweisen. Mechanische, elektrische und insbesondere thermische Einflüsse wirken sich auf die wenigstens zwei Halbleiterschalter unterschiedlich aus. Ein gleichzeitiger Ausfall sämtlicher Halbleiterschalter ist daher unwahrscheinlicher als der Ausfall lediglich eines Halbleiterschalters. Insbesondere führen systematische Fehler bei der Herstellung der Halbleiterschalter zu Abweichungen der Ausfallswahrscheinlichkeiten und erhöhen somit die Sicherheit der erfindungsgemäßen Schaltung gegenüber unbeabsichtigtem fehlerhaftem Einschalten der Last.

Unterschiedliche Eigenschaften weisen Halbleiterschalter auf, die sich in den Typenbezeichnungen einer Baureihe unterscheiden. Unterschiede zwischen den einzelnen Typen liegen beispielsweise in der Spannungsfestigkeit oder beispielsweise im Stromverstärkungsfaktor vor. Unterschiedliche Eigenschaften sind bei Halbleiterschaltern gegeben, die auf einem unterschiedlichen Leitfähigkeitstyp beruhen. Transistoren mit unterschiedlichem Leitfähigkeitstyp sind beispielsweise pnp- oder npn- Transistoren. Unterschiedliche Bauformen der einzelnen Halbleiterschalter führen gleichermaßen zu unterschiedlichen Eigenschaften. Insbesondere ergeben sich hier Abweichungen bei dem thermischen Verhalten. Wesentlich unterschiedliche Eigenschaften liegen vor, wenn den einzelnen Halbleiterschaltern unterschiedliche Wirkungsprinzipien zugrundeliegen. Die Eigenschaften von beispielsweise Bipolartransistoren, Feldeffekttransistoren oder Thyristoren weichen erheblich voneinander ab.

Eine andere vorteilhafte Weiterbildung der erfindungsgemäßen Schaltung sieht vor, daß eine Steuerschaltung an den zweiten Halbleiterschalter unmittelbar ein erstes Steuersignal abgibt. Erfindungsgemäß ist ein von der Steuerschaltung unabhängiger Invertierer vorgesehen, der das von der Steuerschaltung für den ersten Halbleiterschalter bereitgestellte Steuersignal invertiert. Diese Weiterbildung stellt sicher, daß bei einem Defekt der Steuerschaltung, bei dem beide Steuersignale einem Einschaltsignal entsprechen würden, dennoch die Last abgeschaltet bleibt.

Die erfindungsgemäße Schaltung ist insbesondere geeignet zum Ein- und Ausschalten eines Magnetventils als elektrische Last. Das Magnetventil ist vorzugsweise in einem öl- oder gasbetriebenen Heizgerät eingesetzt. In dieser Anwendung ist die ordnungsgemäße Funktion der Halbleiterschalter sowie des Magnetventils von besonderer Wichtigkeit.

Die erfindungsgemäße Schaltung kann in der Anwendung bei einem Heizgerät in mehrfacher Ausfertigung enthalten sein. Aus Sicherheitsgründen ist beispielsweise eine Serienschaltung von zwei Magnetventilen vorgesehen, die jeweils mit der erfindungsgemäßen Schaltung ein- und ausgeschaltet werden. Die beschriebenen Sicherheitskonzepte, die sich auf eine Schaltung bezogen haben, können vorteilhafter Weise die weiteren Schaltungen einbeziehen.

Weitere vorteilhafte Weiterbildungen und Ausgestaltungen der erfindungsgemäßen Schaltung zum Ein- und Ausschalten einer elektrischen Last ergeben sich aus weiteren abhängigen Ansprüchen und aus der folgenden Beschreibung.

### Zeichnung

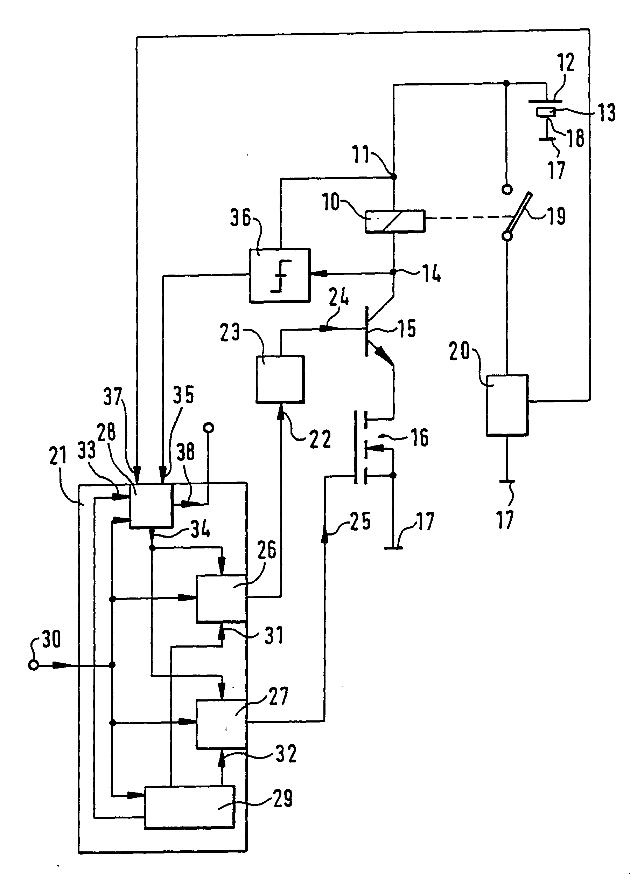

Die Figur zeigt ein Blockschaltbild einer erfindungsgemäßen Schaltung zum Ein- und Ausschalten einer elektrischen Last.

Die Figur zeigt eine elektrische Last 10, deren erster Anschluß 11 mit einem ersten Anschluß 12 einer Energiequelle 13 verbunden ist. Ein zweiter Anschluß 14 der Last 10 ist mit einem ersten Halbleiterschalter 15 verbunden, der in Reihe geschaltet ist mit einem zweiten Halbleiterschalter 16. Der zweite Halbleiterschalter 16 ist mit einer Masse 17 verbunden, an der auch ein zweiter Anschluß 18 der Energiequelle 13 angeschlossen ist. Die Last 10 löst eine Funktion 19 in einem Verbraucher 20 aus. Im gezeigten Ausführungsbeispiel entspricht die Funktion 19 einem Schaltvorgang, der den Verbraucher 20 mit der Energiequelle 13 verbindet.

Anstelle des ersten und des zweiten Halbleiterschalters 15, 16 kann eine erste Gruppe von Halbleiterschaltern 15 und wenigstens eine zweite Gruppe von Halbleiterschaltern 16 vorgesehen sein. Der erste Halbleiterschalter 15 erhält ein von einer Steuerschaltung 21 bereitgestelltes erstes Steuersignal 22 zugeleitet, das ein Invertierer 23 in ein invertiertes Steuersignal 24 umsetzt. Ein zweites Steuersignal 25, das dem zweiten Halbleiterschalter 16 zugeführt ist, stellt die Steuerschaltung 21 unmittelbar bereit.

Die Steuerschaltung 21 enthält eine erste und zweite Treiberschaltung 26, 27, einen Vergleicher 28 sowie eine Auswahlschaltung 29. Den beiden Treiberschaltungen 26, 27, dem Vergleicher 28 und der Auswahlschaltung 29 sind ein externes Schaltsignal 30 zugeführt.

Die Auswahlschaltung 29 gibt an die erste Treiberschaltung 26 ein erstes Schaltsignal 31 und an die zweite Treiberschaltung 27 ein zweites Schaltsignal 32 ab. Weiterhin gibt die Auswahlschaltung 29 ein Statussignal 33 ab, das dem Vergleicher 28 zugeleitet ist.

Die erste Treiberschaltung 26 stellt das erste Steuersignal 22 und die zweite Treiberschaltung 27 das zweite Steuersignal 25 bereit.

Der Vergleicher 28 erzeugt ein Abschaltsignal 34, das den beiden Treiberschaltungen 26, 27 zugeleitet ist. Weiterhin gibt der Vergleicher 33 ein Alarmsignal 38 nach außen ab. Der Vergleicher erhält ein Einschaltzustandssignal 35 zugeführt, das ein Komparator 36 abgibt. Der Komparator 36 ist mit den beiden Anschlüssen 11, 14 der Last 10 verbunden und vergleicht die an der Last 10 auftretende Spannung mit einem vorgegebenen Schwellenwert.

Der Vergleicher 28 erhält weiterhin ein Verbraucheraktivitätssignal 37 zugeleitet, das der Verbraucher 20 bereitstellt.

Die erfindungsgemäße Schaltung zum Ein- und Ausschalten der Last 10 arbeitet folgendermaßen:

Die erfindungsgemäße Schaltung ist zum Ein- und Ausschalten der Last 10 vorgesehen. Die Reihenschaltung des ersten Halbleiterschalters 15 mit wenigstens dem zweiten Halbleiterschalter 16 erhöht erheblich die Sicherheit der Schaltung. Ein Defekt eines der beiden Halbleiterschalter 15, 16 hat noch nicht zur Folge, daß die Last 10 zwangsläufig eingeschaltet wird. Die erhöhte Sicherheit ist insbesondere bei der Auslösung von sicherheitsrelevanten Funktionen 19 durch die elektrische Last 10 erforderlich. Anstelle der in der Figur gezeigten beiden Halbleiterschalter 15, 16 sind gegebenenfalls eine Gruppe von ersten Halbleiterschaltern 15 sowie gegebenenfalls wenigstens eine Gruppe von weiteren Halbleiterschaltern 16 vorgesehen. Die Halbleiterschalter 15 der ersten Gruppe werden vom invertierten Steuersignal 24 und die Halbleiterschalter 16 der zweiten Gruppe vom zweiten Steuersignal 25 angesteuert. Die Erhöhung der Anzahl von Halbleiterschaltern, die in Reihe geschaltet sind, weist den Vorteil einer weiteren Erhöhung der Sicherheit auf.

Eine besonders vorteilhafte Maßnahme zur Erhöhung der Sicherheit sieht vor, daß der erste und zweite Halbleiterschalter 15, 16 unterschiedliche Eigenschaften aufweisen. Als Halbleiterschalter 15, 16 können beispielsweise Kleinsignal-Schalttransistoren gleicher Bauform vorgesehen sein. Unterschiedliche Eigenschaften weisen Transistoren mit unterschiedlichen Typenbezeichnungen in einer Baureihe auf. Diese Transistoren unterscheiden sich beispielsweise in der Spannungsfestigkeit oder beispielsweise im Stromverstärkungsfaktor.

Eine andere Möglichkeit, unterschiedliche Eigenschaften der beiden Halbleiterschalter 15, 16 zu erhalten, sieht den Einsatz von Halbleiterschaltern 15, 16 mit unterschiedlichem Leitfähigkeitstyp vor. Werden als Halbleiterschalter 15, 16 Transistoren verwendet, dann weisen eine pnp- und eine npn-Struktur unterschiedliche Eigenschaften auf. Werden beispielsweise Feldeffekttransistoren, insbesondere MOS-Feldeffekttransistoren eingesetzt, werden unterschiedliche Eigenschaften durch den Einsatz von p-Kanal und von n-Kanal-Feldeffekttransistoren erzielt.

Eine andere vorteilhafte Möglichkeit sieht vor, daß die Halbleiterschalter 15, 16 unterschiedliche Bauformen aufweisen. Unterschiedliche Bauformen weisen stets ein unterschiedliches thermisches Verhalten und somit unterschiedliche Eigenschaften auf.

Eine weitere Möglichkeit, unterschiedliche Eigenschaften der Halbleiterschalter 15, 16 vorzugeben, bietet die Zugrundelegung unterschiedlicher Wirkungsprinzipien des ersten Halbleiterschalters 15 gegenüber dem zweiten Halbleiterschalter 16. Beispielsweise ist der erste Halbleiterschalter ein Bipolartransistor, während der zweite Halbleiterschalter beispielsweise ein Feldeffekttransistor, vorzugsweise ein MOS-Feldeffekttransistor ist. Andere Wirkungsprinzipien sind gegeben beispielsweise bei Darlingtontransistoren, Thyristoren oder Zweiwegthyristoren (Triac), ein- und ausschaltbare Thyristoren usw. Insbesondere geeignet ist eine Kombination von einem Bipolartransistor mit einem Feldeffekttransistor, vorzugsweise einem MOS-Feldeffekttransistor. Diese beiden Halbleiterbauelemente sind für die unterschiedlichsten Leistungsbereiche bei vergleichbaren Bauformen erhältlich.

Eine andere besonders vorteilhafte Maßnahme zur Erhöhung der Sicherheit sieht den Invertierer 23 vor, der das erste Steuersignal 22 invertiert und als invertiertes Steuersignal 24 dem ersten Halbleiterschalter 15 zuführt. Wesentlich ist es, daß der Invertierer 23 ein unabhängiges Schaltungsteil von der Steuerschaltung 21 bildet. Die Steuerschaltung 21 ist vorzugsweise in einem Mikroprozessor oder einem anderen herstellerseitig programmierbaren logischen Bauelement realisiert. Sofern bei einem Defekt der Steuerschaltung 21 der Zustand auftreten kann, daß die beiden Treiberschaltungen 26, 27 Steuersignale 22, 25 mit gleichem Pegel abgeben, verhindert der Invertierer 23 zuverlässig ein fehlerhaftes Einschalten der Last 10.

Die erfindungsgemäße Schaltung ermöglicht eine weitere Erhöhung der Betriebssicherheit durch das Auswerten des vom Komparator 36 bereitgestellten Einschaltzustandssignals 35, das dem Vergleicher 28 zugeführt ist. Der Komparator 36 vergleicht die an der Last 10 auftretende Spannung mit einem vorgegebenen Schwellenwert, der einem Einschaltzustand der Last 10 entspricht.

Eine erste Maßnahme sieht eine Plausibilitätskontrolle vor, der das Einschaltzustandssignal 35, das der Steuerschaltung 21 zugeführte externe Schaltsignal 30 sowie das Verbraucheraktivitätssignal 37 zugrundegelegt sind. Eine erste Plausibilitätskontrolle liefert der Vergleich des Einschaltzustandssignals 35 mit dem externen Schaltsignal 30. Bei dieser Plausibilitätskontrolle findet eine Überprüfung der Halbleiterschalter 15, 16 statt. Eine Überprüfung des ersten Halbleiterschalters 15 schließt eine Überprüfung des Invertierers 23 sowie der ersten Treiberschaltung 26 ein. Eine Überprüfung des zweiten Halbleiterschalters 16 schließt eine Überprüfung der zweiten Treiberschaltung 27 ein.

Ein fehlerhafter Zustand liegt vor, wenn bei einem externen Schaltsignal 30, das einem eingeschalteten Zustand der Last 10 entspricht, das Schaltzustandssignal 35 nicht auftritt oder wenn bei einem externen Schaltsignal 30, das dem abgeschalteten Zustand der Last 10 entspricht, ein Einschaltzustandssignal 35 auftritt. Stellt der Vergleicher 28 durch den Signalvergleich fest, daß ein derartiger Fehler vorliegt, so veranlaßt der Vergleicher 28 die Ausgabe des Abschaltsignals 34 sowie gegebenenfalls die Ausgabe des Alarmsignals 38. Die Last 10 und der die Last 10 enthaltende Verbraucher 20 sind mit dieser Maßnahme in den sicheren abgeschalteten Zustand überführbar.

Eine andere Plausibilitätskontrolle bezieht den Verbraucher 20 ein. Der Vergleicher 28 kann das Verbraucheraktivitätssignal 37 sowohl mit dem Einschaltzustandssignal 35 als auch mit dem externen Schaltsignal 30 vergleichen. Insbesondere aus einem Vergleich des Verbraucheraktivitätssignals 37 mit dem Einschaltzustandssignal 35 der Last 10 kann auf einen Defekt im Verbraucher 20 geschlossen werden. Ein Abschalten des Verbrauchers 20 bei einem festgestellten Einschaltzustandssignal 35 der Last 10 ist dann allerdings nicht möglich, da keine weitere Eingriffsmöglichkeiten in den Verbraucher 20 vorgesehen sind. Der Vergleicher 28 kann aber in jedem Fall das Alarmsignal 38 abgeben.

Eine besonders vorteilhafte weitere Möglichkeit der Funktionskontrolle bietet die erfindungsgemäß vorgesehene Auswahlschaltung 29. Die Auswahlschaltung 29 ermöglicht über das erste oder zweite Schaltsignal 31, 32 sowohl ein Einschalten als auch ein Ausschalten des ersten Halbleiterschalters 15 und/oder des zweiten Halbleiterschalters 16. Der wesentliche Vorteil liegt zum einen darin, daß die Auswahlschaltung 29 die Schaltsignale 31, 32 getrennt für die beiden Halbleiterschalter 15, 16 bereitstellen kann und zum anderen darin, daß die Bereitstellung der Schaltsignale 31, 32 unabhängig vom externen Schaltsignal 30 erfolgen kann. Es ist somit möglich, einen Halbleiterschalter 15, 16 ausfindig zu machen, der entweder ständig im leitenden Zustand ist oder der nicht mehr eingeschaltet werden kann.

Der wesentliche Vorteil, der durch die Auswahlschaltung 29 gegeben ist, liegt in der Möglichkeit der Plausibilitätskontrolle sowohl im abgeschalteten als auch insbesondere im eingeschalteten Zustand der Last 10. Sämtliche in Verbindung mit dem externen Schaltsignal 30 erwähnten Plausibilitätskontrollen sind mit der Auswahlschaltung 29 auf flexible Weise möglich. Das von der Auswahlschaltung 29 bereitgestellte Statussignal 33 liefert dem zweiten Vergleicher 28 stets die Information, welcher der Halbleiterschalter 15, 16 ein- oder ausgeschaltet ist, und daß die Last 10 eingeschaltet oder ausgeschaltet sein soll. Mit dem Alarmsignal 38, das gegebenenfalls ausgegeben wird, kann gleichzeitig angegeben werden, welcher Halbleiterschalter 15, 16 defekt ist.

Eine besonders vorteilhafte Maßnahme sieht vor, daß die Auswahlschaltung 29 die zeitliche Dauer der beiden Schaltsignale 31, 32 festlegen kann. Mit dieser Maßnahme können besondere Betriebszustände des Verbrauchers 20 berücksichtigt werden.

Die Festlegung auf eine erste kurze Zeitdauer ist vorzugsweise zur Überprüfung der Halbleiterschalter 15, 16 vorgesehen, die auf die bereits beschriebenen Weise erfolgt. Die erste Zeitdauer ist auf einen Wert festzulegen, bei dem der Verbraucher 20 sowohl im abgeschalteten als auch im eingeschalteten Zustand unbeeinflußt bleibt. Ein solcher Verbraucher weist beispielsweise eine Verzögerungszeit zwischen dem Ein-/Ausschalten und dem daraus resultierenden Ein- oder Ausschaltzustand auf.

Die Festlegung auf eine zweite längere Zeit ist vorgesehen, um die Last 10 selbst überprüfen zu können. In Abhängigkeit von der Ausgestaltung der Last 10 kann ein Zustand auftreten, bei dem die Last 10 defekt ist, obwohl das Einschaltzustandssignal 35 nicht vorliegt. Ein solcher Zustand kann beispielsweise bei einem Relais oder beipielsweise bei einem Magnetventil auftreten, wobei die Magnetwicklung stromlos ist, aber die Relaiskontakte kleben oder das Magnetventil im geöffneten Zustand verklemmt ist. Gibt die Auswahlschaltung 29 die Abschaltsignale 31, 32 mit der längeren Zeitdauer aus, bei der eine Reaktion des Verbrauchers 20 feststellbar ist, kann aufgrund des Verbraucheraktivitätssignals 37 festgestellt werden, daß die Last 10 defekt ist, wobei aber das Einschaltzustandssignal 35 korrekt vorliegt.

Die erfindungsgemäße Schaltung eignet sich insbesondere zur Verwendung in sicherheitsrelevanten Verbrauchern 20, welche die Last 10 enthalten. Ein solcher Verbraucher 20 ist beispielsweise ein öl- oder insbesondere ein gasbetriebenes Heizgerät. Als Last 10 ist beispielsweise ein Magnetventil vorgesehen, das einen Gasfluß freigibt oder sperrt. Das Verbraucheraktivitätssignal 37 ist bei einem öl- oder gasbetriebenen Heizgerät vorzugsweise ein Flammenüberwachungssignal.
In sicherheitsrelevanten Verbrauchern 20 kann die erfindungsgemäß vorgeschlagene Schaltung mehrfach vorhanden sein. Beispielsweise kann eine Reihenschaltung mit zwei Magnetventilen bei einem öl- oder gasbetriebenen Heizgerät vorgesehen sein. Die Diagnosemöglichkeiten können ohne weiteres über mehrere Lasten 10 erstreckt werden. Insbesondere ist es möglich, eine der mehreren vorhandenen Lasten 10 unter Einbeziehung des Verbraucheraktivitätssignals 37 als defekt zu erkennen, wenn eine Last 10 eingeschaltet ist und auf die andere Last 10 das beschriebene Vorgehen angewendet wird.

## Patentansprüche

1. Schaltung zum Ein- und Ausschalten einer elektrischen Last (10)
- mit wenigstens zwei in Reihe mit der Last (10) geschalteten Halbleiterschaltern (15, 16),
- mit einem Komparator (36), der die an der Last (10) auftretende Spannung mit einem vorgegebenen Schwellenwert vergleicht und der ein Einschaltzustandssignal (35) abgibt, das einen Einschaltzustand der elektrischen Last (10) anzeigt,
- mit einem Vergleicher (28), der das Einschaltzustandssignal (35) mit wenigstens einem Signal (30, 31, 32, 33, 37) vergleicht,
- mit einer Auswahlschaltung (29), die zum einen Schaltsignale (31, 32) abgibt, welche die Halbleiterschalter (15, 16) getrennt oder zusammen entweder ein- oder ausschalten, wobei die Auswahlschaltung (29) die Schaltsignale (31, 32) eine erste kürzere Zeit oder eine zweite längere Zeit abgibt, und die zum anderen ein Statussignal (33) zum Vergleicher (28) abgibt, das einen von den Schaltsignalen (31, 32) festgelegten Einschalt- oder Ausschaltzustand der Last (10) wiedergibt.

2. Schaltung nach Anspruch 1, bei der dem Vergleicher (28) weiterhin ein einer Steuerschaltung (21) zugeführtes externes Schaltsignal (30) zugeleitet ist.

3. Schaltung nach Anspruch 1, bei der die Halbleiterschalter (15, 16) unterschiedliche Eigenschaften aufweisen.

4. Schaltung nach Anspruch 3, bei der innerhalb einer Halbleiter-Baureihe unterschiedlich bezeichnete Typen eingesetzt sind.

5. Schaltung nach Anspruch 3, bei der die Halbleiterschalter (15, 16) einen unterschiedlichen Leitfähigkeitstyp aufweisen.

6. Schaltung nach Anspruch 3, bei der die Halbleiterschalter (15, 16) unterschiedliche Bauformen aufweisen.

7. Schaltung nach Anspruch 3, bei der den Halbleiterschaltern (15, 16) unterschiedliche Wirkungsprinzipien zugrundeliegen.

8. Schaltung nach Anspruch 7, bei der ein erster Halbleiterschalter (15) ein Bipolartransistor und ein zweiter Halbleiterschalter (16) ein Feldeffekttransistor, vorzugsweise ein MOS-Feldeffekttransistor ist.

9. Schaltung nach Anspruch 1, bei der eine Steuerschaltung (21) vorgesehen ist, die ein erstes Steuersignal (22) an den ersten Halbleiterschalter (15) abgibt, bei der ein Invertierer (23) vorgesehen ist, der das erste Steuersignal (22) invertiert und als invertiertes Steuersignal (24) dem ersten Halbleiterschalter (15) zuführt, und bei der die Steuerschaltung (21) ein zweites Steuersignal (25) abgibt, das dem zweiten Halbleiterschalter (16) unmittelbar zugeführt ist.

10. Schaltung nach Anspruch 1 und 9, bei der die Auswahlschaltung (29) in der Steuerschaltung (21) enthalten ist.

11. Schaltung nach Anspruch 1, bei der dem Vergleicher (28) weiterhin ein Verbraucheraktivitätssignal (37) zugeleitet ist, das ein die Last (10) enthaltender Verbraucher (20) bereitstellt.

12. Schaltung nach Anspruch 1, bei der als Last (10) ein Magnetventil vorgesehen ist, das in einem öl- oder gasbetriebenen Heizgerät (20) angeordnet ist.

13. Schaltung nach Anspruch 11 und 12, bei der das Verbraucheraktivitätssignal (37) ein Flammenüberwachungssignal ist.

## Claims

1. Circuit for switching an electrical load (10) on and off,
- having at least two semiconductor switches (15, 16) connected in series with the load (10),
- having a comparator (36), which compares the voltage that occurs across the load (10) with a predetermined threshold value and which outputs a switched-on state signal (35), which indicates a switched-on state of the electrical load (10),
- having a comparator (28), which compares the switched-on state signal (35) with at least one signal (30, 31, 32, 33, 37),
- having a selection circuit (29), which, on the one hand, outputs switching signals (31, 32), which switch the semiconductor switches (15, 16) either on or off separately or together, the selection circuit (29) outputting the switching signals (31, 32) for a first, shorter time or a second, longer time, and which, on the other hand, outputs a status signal (33) to the comparator (28), which status signal represents a switched-on or switched-off state of the load (10) defined by the switching signals (31, 32).

2. Circuit according to Claim 1, in which an external switching signal (30) fed to a control circuit (21) is furthermore forwarded to the comparator (28).

3. Circuit according to Claim 1, in which the semiconductor switches (15, 16) have different properties.

4. Circuit according to Claim 3, in which use is made of differently designated types within a semiconductor series.

5. Circuit according to Claim 3, in which the semiconductor switches (15, 16) have a different conductivity type.

6. Circuit according to Claim 3, in which the semiconductor switches (15, 16) have different physical forms.

7. Circuit according to Claim 3, in which the semiconductor switches (15, 16) are based on different principles of operation.

8. Circuit according to Claim 7, in which a first semiconductor switch (15) is a bipolar transistor, and a second semiconductor switch (16) is a field-effect transistor, preferably a MOS field-effect transistor.

9. Circuit according to Claim 1, in which a control circuit (21) is provided, which outputs a first control signal (22) to the first semiconductor switch (15), in which an inverter (23) is provided, which inverts the first control signal (22) and feeds it as inverted control signal (24) to the first semiconductor switch (15), and in which the control circuit (21) outputs a second control signal (25), which is fed directly to the second semiconductor switch (16).

10. Circuit according to Claims 1 and 9, in which the selection circuit (29) is contained in the control circuit (21).

11. Circuit according to Claim 1, in which a burden activity signal (37) is furthermore forwarded to the comparator (28), which signal is provided by a burden (20) which contains the load (10).

12. Circuit according to Claim 1, in which a solenoid valve is provided as the load (10) and is arranged in an oil- or gas-operated heater (20).

13. Circuit according to Claims 11 and 12, in which the burden activity signal (37) is a flame monitoring signal.

## Revendications

1. Circuit de commutation d'une charge électrique (10) comprenant :
- au moins deux commutateurs semi-conducteurs (15, 16) branchés en série sur la charge (10),
- un comparateur (36) qui la tension aux bornes de la charge (10) compare à un seuil prédéterminé, et qui émet un signal d'état de branchement (35) indiquant un état de branchement de la charge électrique (10),
- un comparateur (28) comparant le signal d'état de branchement (35) avec au moins un signal (30, 31, 32, 33, 37),
- un sélecteur (29) qui émet, d'une part, des signaux de commutation (31, 32) commutant séparément ou globalement les commutateurs semi-conducteurs (15, 16), le sélecteur (29) émettant les signaux de commutation (31, 32) après un premier temps plus court ou un second temps plus long, et qui d'autre part fournit un signal d'état (33) au comparateur (28), qui restitue un état de branchement ou de coupure de la charge (10), fixé à partir des signaux de commutation (31, 32).

2. Circuit selon la revendication 1,
caractérisé en ce que
le comparateur (28) reçoit en outre un signal de commutation externe (30) appliqué à un circuit de commande (21).

3. Circuit selon la revendication 1,
caractérisé en ce que
les commutateurs semi-conducteurs (15, 16) ont des propriétés différentes.

4. Circuit selon la revendication 3,
caractérisé en ce qu'
on utilise des types différents de composants semi-conducteurs dans une même série de fabrication.

5. Circuit selon la revendication 3,
caractérisé en ce que
les commutateurs semi-conducteurs (15, 16) correspondent à un type de conductivité différent.

6. Circuit selon la revendication 3,
caractérisé en ce que
les commutateurs semi-conducteurs (15, 16) ont des formes de construction différentes.

7. Circuit selon la revendication 3,
caractérisé en ce que
les commutateurs semi-conducteurs (15, 16) correspondent à des principes de fonctionnement différents.

8. Circuit selon la revendication 7,
caractérisé en ce que
le premier commutateur semi-conducteur (15) est un transistor bipolaire et le second commutateur semi-conducteur (16) est un transistor à effet de champ, de préférence un transistor MOS.

9. Circuit selon la revendication 1,
caractérisé en ce qu'
il comporte un circuit de commande (21) émettant un premier signal de commande (22) pour le premier commutateur semi-conducteur (15), un inverseur (23) qui inverse le premier signal de commande (22) et l'applique comme signal de commande inversé (24) au premier commutateur semi-conducteur (15), le circuit de commande (21) émettant un second signal de commande (25) appliqué directement au second commutateur semi-conducteur (16).

10. Circuit selon les revendications 1 et 9,
caractérisé en ce que
le sélecteur (29) fait partie du circuit de commande (21).

11. Circuit selon la revendication 1,
caractérisé en ce que
le comparateur (28) reçoit en outre un signal d'activité de consommateur (37) fourni par un consommateur (20) contenant la charge (10).

12. Circuit selon la revendication 1,
caractérisé en ce que
la charge (10) est une électrovanne équipant un appareil de chauffage au fuel ou au gaz (20).

13. Circuit selon la revendication 11 et 12,
caractérisé en ce que
le signal d'activité de consommateur (37) est un signal de surveillance de flammes.
